Europäisches Patentamt

European Patent Office

Office européen des brevets

(11) Publication number: **0 263 287**
**A2**

## (12) EUROPEAN PATENT APPLICATION

(21) Application number: **87112331.1**

(22) Date of filing: **25.08.87**

(51) Int. Cl.⁴: **H01L 21/82** , **H01L 23/56**

(30) Priority: **29.09.86 US 913832**

(43) Date of publication of application:
**13.04.88 Bulletin 88/15**

(84) Designated Contracting States:
**DE FR GB**

(71) Applicant: **International Business Machines Corporation**
**Old Orchard Road**
**Armonk, N.Y. 10504(US)**

(72) Inventor: **Muggli, Raymond Allen**
**7030 ia Del Rio**
**San Jose California 95139(US)**
Inventor: **McCaffrey, Terence Patrick**
**11154 La Paloma Drive**
**Cupertino California 95014(US)**

(74) Representative: **Hobbs, Francis John**
**IBM United Kingdom Limited Intellectual**
**Property Department Hursley Park**
**Winchester Hampshire SO21 2JN(GB)**

(54) Forming a capacitor in an integrated circuit.

(57) A capacitor is formed in an integrated circuit at the same time as field effect transistors, by the successive steps of: forming a well (22) of a first conductivity type in a semiconductor substrate (21); forming a high concentration impurity region of a second conductivity type in the well to form a first capacitor plate (23) at the same time that the impurity regions for the sources and drains of the transistors are formed; forming an oxide layer (24) having access holes over the impurity region to form the capacitor dielectric at the same time that the oxide layer for the gates of the transistors is formed; forming a layer of high conductivity material (e.g. 26a) over the oxide layer to form a second capacitor plate; and forming a layer (25) of metallization over the oxide and impurity region in the access holes to provide electrical connection to the first capacitor plate (23).

FIG. 2A

## FORMING A CAPACITOR IN AN INTEGRATED CIRCUIT

This invention relates to a method of forming a capacitor in an integrated circuit at the same time as field effect transistors are formed therein.

In integrated circuit design, on-chip capacitors are frequently required. Such capacitors should have high capacitance per unit area and a capacitance value that does not change with variation in the voltage applied to the capacitor. Where such characteristics have been produced, additional processing steps are usually required.

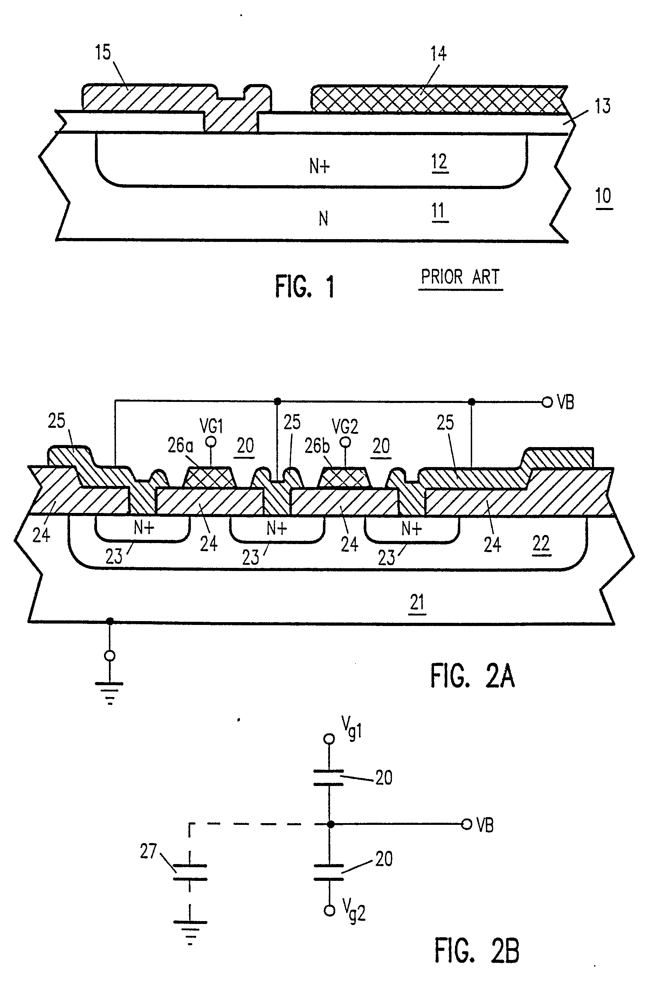

In Fig. 1 of the accompanying drawings, a conventional CMOS capacitive element 10 is represented in cross-section. Such elements are typically located apart from other elements on the chip. Furthermore, at least one additional process step is required to form oxide layer 13 over N+ diffused region 12 in N-well 11 to insulate electrode 14 from electrode 15.

Other prior art semiconductor chip capacitors which are formed without additional process steps usually have at least one semiconductor plate. For example, US -A-4,384,218 discloses a MOS capacitor having only one polysilicon plate while the other plate comprises semiconductor regions in the substrate. See also US -A-4,216,451, US -A-4,536,947, US -A-4,559,548 and US -A-4,570,331. Such capacitors are notorious for instability of capacitance with variations in applied voltage.

The present invention seeks to provide a capacitor having high capacitance per unit area, stable capacitance value with changes in applied voltage, and requiring no additional process steps to be formed over the number required for processing field effect transistors on the chip.

The invention provides a method of forming a capacitor in an integrated circuit at the same time as field effect transistors are formed, the method comprising the successive steps of: forming a well of a first conductivity type in a semiconductor substrate; forming a high concentration impurity region of a second conductivity type in the well to form a first capacitor plate at the same time that the impurity regions for the sources and drains of the transistors are formed; forming an oxide layer having access holes over the impurity region to form the capacitor dielectric at the same time that the oxide layer for the gates of the transistors is formed; forming a layer of high conductivity material over the oxide layer to form a second capacitor plate; and forming a layer of metallization over the oxide and impurity region in the access holes to provide electrical connection to the first capacitor plate.

High capacitance per unit area is achieved by using the same oxidation layer for the dielectric as is used for the gates of the FET's. Stability of capacitance value is achieved by incorporating a back plate comprising the same type of diffusion region, formed at the same time, as is used for the sources and drains of the transistors.

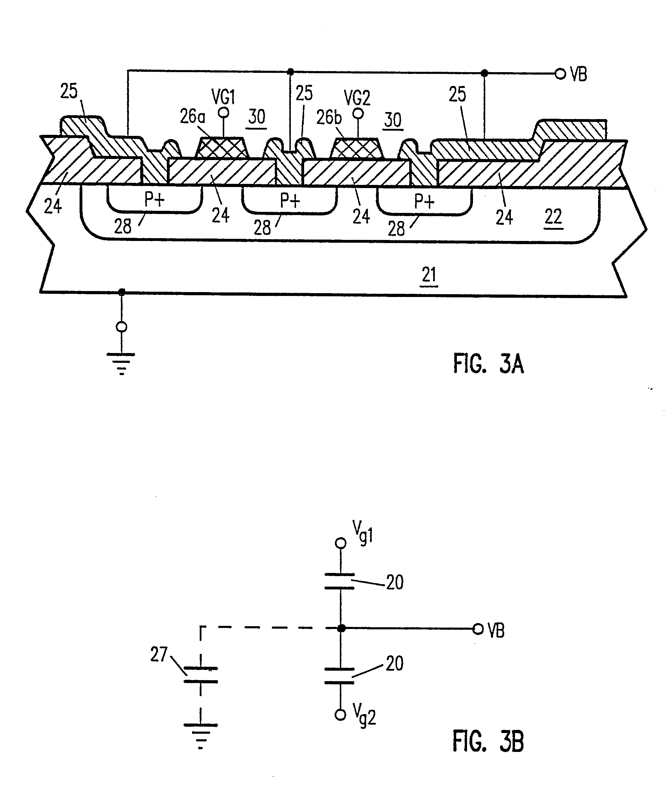

How the invention can be carried into effect will now be described by way of example, with reference to Figs. 2A, 2B, 3A and 3B of the accompanying drawings, in which:-

Fig. 2A represents a cross-section of part of an integrated circuit in which there are capacitors formed by a method embodying the invention;

Fig. 2B is a circuit diagram of the capacitors depicted in Fig. 2A;

Fig. 3A represents a cross-section of part of an integrated circuit in which there are capacitors formed by another method embodying the present invention; and

Fig. 3B is a circuit diagram of the capacitors depicted in Fig. 3A.

Capacitors 20 (Fig. 2A) comprise N+ diffused regions 23, silicon dioxide layer portions 24, and polysilicon layer portions 26a and 26b. Regions 23 form part of one of the capacitor plates to which electrical contact is made via metallization layer portions 25. The polysilicon layer portions 26a and 26b form the other plate to which bias voltage is applied directly. Silicon dioxide layer 24 is used as the dielectric between capacitor plates formed by regions 23 and polysilicon layers 26a and 26b, which yields high capacitance per unit area.

Capacitors 20 are formed in N-well 22 on P-substrate 21 using well-known CMOS processing technology. N+ diffused regions 23 are formed during the same diffusion step that forms the source and drain diffusion for N-channel FET's (not shown) located elsewhere on the same substrate. Dielectric 24 is formed during the same step which forms the gate oxidation layer for the FET's. Thus, no additional processing steps are required to form capacitors 20.

A circuit diagram of the capacitors 20 when biased is shown in Fig. 2B. While two capacitors 20 are shown, the structure and process steps are the same for a single capacitor. It should be noted also that parasitic capacitor 27 arises from the junction of N-well 22 and substrate 21.

With continuing reference to Fig. 2B, the substrate is biased at ground or at the most negative voltage of the circuit in which the capacitor is used. By keeping $V_{g1}$ and $V_{g2}$ greater than $V_b$, inversion of the silicon surface under capacitor dielectric layer portions 24 is precluded. Moreover, $V_b$ also provides equipotential biasing of layer portions 24, the effect of which is described in more detail subsequently herein.

Referring now to Fig. 3, a similar structure is shown for capacitors 30. In this configuration, P + diffusion regions 28 are used in lieu of N + diffusion regions 23 to form part of one of the plates of capacitors 30. The dielectric layer, second capacitor plate and electrical contact connection have the same structure and require the same process steps as those formed in the configuration of Fig. 2A. P + diffusion regions 28 are formed during the same process steps which form the P-channel FET source and drain diffusions.

Referring finally to Fig. 3B, for the structure of Fig. 3A to function as a good capacitor, the silicon region under capacitor dielectric layer 24 must be inverted to P-type. For a typical application, the useful range of bias voltage, $V_b$ is given by

$$V_b \; -V_t \geq V_{g1} \text{ or } V_{g2}$$

where the threshold voltage, $V_t$, is approximately -0.8 volts.

As previously noted herein, $V_b$ provides an equipotential voltage level to dielectric layers 24 via the capacitor plates formed by regions 23 in the two-capacitor configuration of Fig. 2A. In this biasing configuration therefore, there exists an equivalent capacitor comprising two plates 26a and 26b dielectrically separated by two dielectric layers 24 biased at the same voltage as regions 23. While parasitic capacitor 27 shown in Fig. 2B cannot be ignored, it can be minimised or modelled to provide the useful equivalent metal-oxide-metal capacitor described above.

## Claims

1. A method of forming a capacitor (20) in an integrated circuit at the same time as field effect transistors are formed, the method comprising the successive steps of:

forming a well (22) of a first conductivity type in a semiconductor substrate (21);

forming a high concentration impurity region of a second conductivity type in the well to form a first capacitor plate (23) at the same time that the impurity regions for the sources and drains of the transistors are formed;

forming an oxide layer (24) having access holes over the impurity region to form the capacitor dielectric at the same time that the oxide layer for the gates of the transistors is formed;

forming a layer of high conductivity material (e.g. 26a) over the oxide layer to form a second capacitor plate; and

forming a layer (25) of metallization over the oxide and impurity region in the access holes to provide electrical connection to the first capacitor plate (23).

2. A method as claimed on claim 1, wherein the first and second conductivity types are the same.

3. A method as claimed in claim 2, wherein the conductivity type of the substrate is different from the first and second conductivity types.

4. A method as claimed in claim 1, wherein the first and second conductivity types are different.

5. A method as claimed in claim 4, wherein the substrate is of the second conductivity type.

6. A method as claimed in claim 5, wherein the second conductivity type is P type.

7. A method as claimed in claim 2, in which the first and second conductivity types are N type, the oxide layer is silicon dioxide, and the high conductivity material is polysilicon.

8. A method of simultaneously forming a pair of capacitors in an integrated circuit, in which each capacitor is formed by a method as claimed in any preceding claim whereby the first capacitor plates of the pair of capacitors are, in operation of the integrated circuit, biased at the same voltage.

9. A method as claimed in claim 8, in which the pair of capacitors are formed at adjacent locations in the integrated circuit so that a third capacitor is comprised by the second capacitor plates of the pair of capacitors and the intervening first capacitor plates and the capacitor dielectric of the pair of capacitors.

10. An integrated circuit having field effect transistors and a capacitor or capacitors formed by a method as claimed in any preceding claim.

FIG. 1    PRIOR ART

FIG. 2A

FIG. 2B

FIG. 3A

FIG. 3B